(19)

**Europäisches Patentamt**
**European Patent Office**
**Office européen des brevets**

(11) **EP 2 360 524 A2**

(12) **EUROPEAN PATENT APPLICATION**

(43) Date of publication:
**24.08.2011 Bulletin 2011/34**

(51) Int Cl.:
*G03F 7/00* (2006.01)          *G03F 9/00* (2006.01)

(21) Application number: **11151246.3**

(22) Date of filing: **18.01.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **24.02.2010 JP 2010039203**

(71) Applicant: **Canon Kabushiki Kaisha**
**Tokyo 146-8501 (JP)**

(72) Inventor: **Shiode, Yoshihiro**
**Tokyo Tokyo 146-8501 (JP)**

(74) Representative: **TBK**
**Bavariaring 4-6**
**80336 München (DE)**

(54) **Imprint apparatus, template of imprint apparatus, and article manufacturing method**

(57)     An imprint apparatus includes a dispenser (7), a detector (5) configured to detect an alignment mark (103) located on a pattern surface of a template, and a controller (C). The pattern surface includes a first region (102) including a pattern corresponding to the resin pattern, and a second region (101) including the alignment mark, and is formed such that a second time when a recess in the second region is filled with the uncured resin is later than a first time when a recess in the first region is filled with the uncured resin. The controller causes the dispenser to dispense, on the substrate, the uncured resin that has an amount such that the recesses in the first and second regions are filled with the uncured resin and causes the detector to detect the alignment mark between the first time and the second time.

# FIG. 1

EP 2 360 524 A2

**Description**

Field of the Invention

The present invention relates to an imprint apparatus, a template for use in the imprint apparatus, and an article manufacturing method.

Description of the Related Art

The imprint technique is capable of transferring nanoscale micropatterns, and beginning to be put into practical use as one nanolithography technique for the mass-production of magnetic recording media and semiconductor devices. In the imprint technique, a template (also called a mold) having a micropattern formed by using an apparatus such as an electron-beam exposure apparatus is used as an original to form the micropattern on a substrate such as a silicon wafer or glass plate. This micropattern is formed by curing an uncured resin dispensed on the substrate while the resin and template are pressed against each other.

Imprint techniques presently put into practical use are the heat cycle method and photo cure method. In the heat cycle method, the fluidity of a thermoplastic resin is increased by heating the resin to a temperature equal to or higher than the glass-transition temperature, and a template is pressed against the resin having a high fluidity. Then, a pattern is formed by releasing the template from the cooled resin. In the photo cure method, a template is pressed against an uncured ultraviolet-curing resin, and the resin is cured by irradiating it with ultraviolet light in this state. After that, a pattern is formed by releasing the template from the cured resin. In the heat cycle method, the transfer time increases due to temperature control, and the dimensional accuracy decreases due to temperature changes. However, the photo cure method has no such problems. Presently, therefore, the photo cure method is advantageous in the mass-production of nanoscale semiconductor devices. Japanese Patent No. 4185941 discloses an imprint apparatus using the photo cure method. This imprint apparatus described in Japanese Patent No. 4185941 includes a substrate stage, a resin dispenser, a head holding a template, an illumination system for irradiating light, and an alignment mark detector.

The die-by-die method or global alignment method is used to perform measurement for aligning a template with an imprint region (also called a shot region) on a wafer in an imprint apparatus. A common problem of these two methods is the possibility of the displacement or deformation of the template while it is pressed. In the conventional imprint apparatus, a force applied to the template while it is pressed from imprint (mold pressing) to mold release may displace or deform the template for each shot. Accordingly, demands have arisen for a method of always measuring the displacement and deformation of the template. As in the die-by-die method, therefore, alignment measurement is necessary while the template is pressed for each shot in the global alignment method as well.

In this alignment measurement performed while the template is pressed, an alignment mark cannot be seen if a resin is filled in the region of the alignment mark, because the refractive index of the resin is close to that of quartz as the material of the template. More accurately, the alignment measurement becomes difficult because the alignment mark has almost no contrast. In the conventional die-by-dye method, therefore, the resin is prevented from entering the region of the alignment mark by, for example, forming a deep trench called a moat around the alignment mark.

The alignment mark is normally formed in a scribe region on the template. If no resin is dispensed on the scribe region including the alignment mark, the scribe region with no resin is etched in an etching step after a lithography step, and this is unfavorable in some cases. Also, the scribe region with no resin deteriorates the etching uniformity of a region to be etched in a device pattern region. Furthermore, no additional alignment mark can be formed in the scribe region. To avoid these inconveniences, a resin must exist even in the scribe region including the alignment mark. As described previously, however, the alignment measurement is difficult in the state in which a resin is filled in the region of the alignment mark.

SUMMARY OF THE INVENTION

The present invention provides an imprint apparatus advantageous in both filling recesses in a region having an alignment mark of a template with an uncured resin, and detecting the alignment mark.

The present invention in its first aspect provides an imprint apparatus as specified in claims 1 to 7.

The present invention in its second aspect provides an article manufacturing method as specified in claim 8.

The present invention in its third aspect provides a template as specified in claim 9.

Further features of the present invention will become apparent from the following description of exemplary embodiments with reference to the attached drawings.

BRIEF DESCRIPTION OF THE DRAWINGS

Fig. 1 is a view showing an imprint apparatus;

Fig. 2 is a flowchart of an imprint process;

Figs. 3A to 3C are conceptual views showing the way a resin is filled;

Fig. 4 is a view showing a template;

Figs. 5A to 5C are views showing the way the resin is filled in recesses of a pattern of the template;

Figs. 6A and 6B are views showing an alignment mark and vicinity;

Fig. 7 is a view showing a detector of the first embodiment;

Fig. 8 is a view showing the template and an alignment mark of a substrate;

Fig. 9 is a view showing a detector of the second embodiment;

Fig. 10 is a view showing a detector of the third embodiment;

Fig. 11A is a view showing an alignment step according to the fifth embodiment; and

Fig. 11B is a view showing an alignment step according to the sixth embodiment.

DESCRIPTION OF THE EMBODIMENTS

First, the alignment between a process on a substrate (wafer) and a template in an imprint apparatus will be explained. The alignment between a process on a wafer and a template is performed by the die-by-die method or global alignment method. In the die-by-die method, when pressing a template against an uncured resin (to be also simply referred to as a resin hereinafter) on a wafer, alignment marks located on the wafer and template are positioned close to each other and simultaneously observed with a detector, and the resin is cured after the displacement amount is corrected. A typical alignment method is the moire alignment method of generating moire fringes based on the relative relationship between the marks on the template and wafer. Lines and spaces are generally used to generate the moire fringes. Letting P1 be the pitch of the mark on the template, and P2 be the pitch of the mark on the wafer, a pitch P3 of the moire fringes is obtained by

$$1/P3 = (1/P1) - (1/P2) \qquad ...(1)$$

where P1 < P2.

When the relative displacement amount between the template and wafer is $\Delta X$, the shift amount of the moire fringe P3 is proportional to the phase difference of a period Pa. Also, when the relationship between the pitch P1 of the mark on the template and the pitch P2 of the mark on the wafer is inverted, moire fringes having the same pitch are generated, but the direction of shift is reversed. By simultaneously observing the two different sets of marks, a relative shift amount S of the moire fringes is given by

$$S = 2 \cdot (\Delta X/Pa) \cdot P3 \qquad ...(2)$$

where Pa = (P1 + P2)/2. By appropriately selecting the pitches P1 and P2 in equations (1) and (2), it is possible to enlarge and accurately measure the actual relative displacement amount between the template and wafer. The moire alignment method can decrease the numerical aperture (NA) by increasing the moire pitch P3 without increasing the optical magnification of an alignment optical system. This makes the moire alignment method very effective in that the alignment accuracy can be increased with a simple optical system.

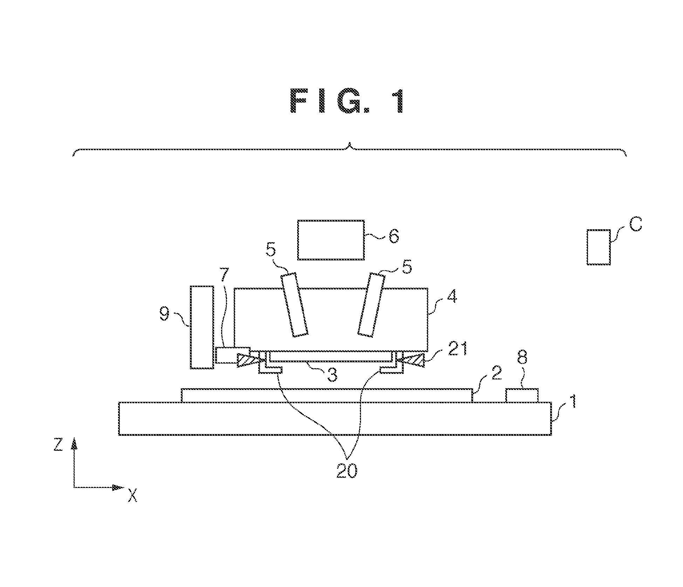

The global alignment method using an additional alignment scope will be explained below. This method will be explained by using Fig. 1 as a schematic view of an imprint apparatus. In this imprint apparatus, an off-axis scope 9 measures alignment marks (not shown) in a plurality of shots on a wafer 2 mounted on a substrate stage (wafer stage) 1, while the wafer stage 1 is driven. The imprint apparatus maps all the shots on the wafer 2 by performing statistical processing on the plurality of measured alignment marks, and performs an imprint process after that without any alignment measurement. The off-axis scope 9 is located outside a head 4 holding a template 3, and hence has a sufficient space unlike detectors (scopes) 5 located in the head 4. This makes it possible to construct a large optical system. Accordingly, the off-axis scope 9 is generally an optical system having process flexibility, for example, having an illumination variation σ, capable of wavelength selection, having a high lens aperture, and capable of switching bright and dark fields at a high magnification.

In the global alignment method, it is always necessary to calibrate the distance (baseline) between the center of the template 3 and the center of the off-axis scope 9. To perform this calibration, the scopes 5 of the head 4 detect the alignment mark of each shot on the wafer 2 and the alignment mark located on the template 3, thereby measuring the relative positions of the center of the template 3 and the shot center on the wafer 2. The relative positions of the center of the template 3 and the short center on the wafer 2 are measured from moire signals generated when the two alignment marks are positioned close to each other. Alternatively, after the scopes 5 measure the relative positions of a stage reference mark 8 on the wafer stage 1 and the alignment mark of the template 3, the stage reference mark 8 is fed under the off-axis scope 9, and the off-axis scope 9 measures the stage reference mark 8. The relative positions (a so-called baseline amount) of the template 3 and off-axis scope 9 can be measured by these methods. Based on this baseline amount, the imprint apparatus performs the imprint process by reflecting the global alignment result below the template 3. A controller C controls the scopes 5, the wafer stage 1, a dispenser 7 for dispensing a resin on the wafer 2, and the like. Embodiments of the template and imprint apparatus will be explained below with reference to the accompanying drawings.

(First Embodiment)

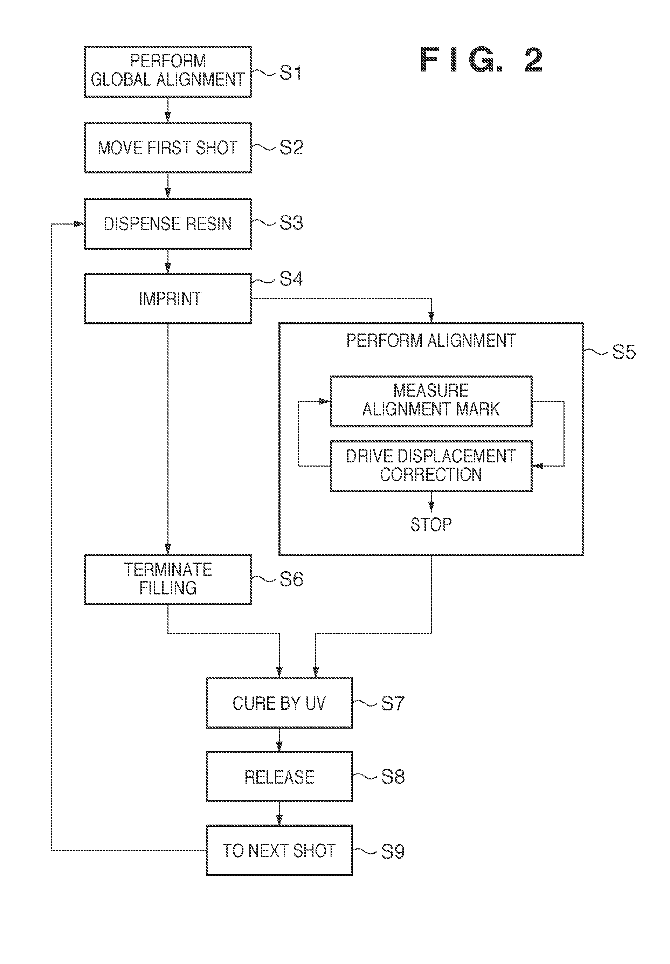

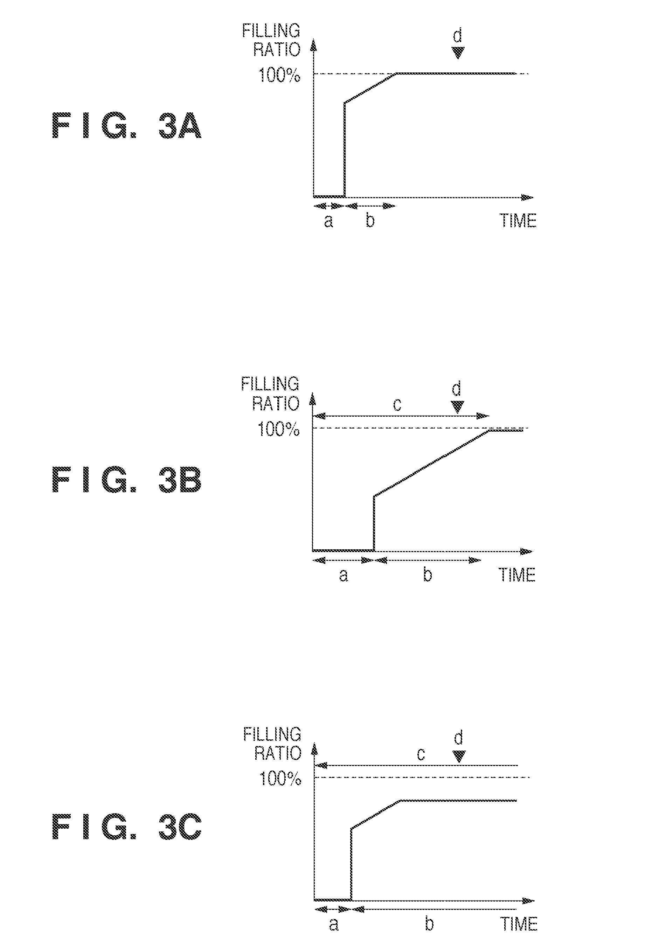

The procedure of the imprint process will be explained below with reference to Fig. 2. The imprint process will be described based on the global alignment method because while the template 3 comes in contact with a resin, there is no difference in alignment between the global alignment method and die-by-die method. In S1, the imprint apparatus performs global alignment by using the off-axis scope 9. In S2, the imprint apparatus drives the wafer stage 1 to move the first shot position of the wafer 2 to a dispensing start position below the dispenser 7. In S3, the imprint apparatus dispenses a resin on the first shot while scanning the wafer stage 1. In S4, the imprint apparatus drives the wafer stage 1 to move the first shot to a position immediately below the template 3, and starts an imprint step. In this imprint step, nozzles 20 discharge helium (He) to fill the space between the template 3 and wafer 2 with He, in order to purge oxygen.
A process in which the resin is filled in pattern recesses of the template 3 in the imprint step will be explained below. Figs. 3A to 3C are conceptual views showing the way the resin is filled in recesses forming the pattern of the template 3 in the pattern region of the template 3 as the time elapses from the start of imprint.
A time zone a is a time zone in which the resin dropped on the wafer 2 spreads in the pattern region of the template 3. The length of the time zone a changes in accordance with the positions of the dropped resin and pattern as well. When the time zone a is over, the imprint apparatus starts filling the resin in the recesses of the template 3. As shown in Fig. 3A, the resin is abruptly filled in the device pattern (resin pattern) region (first region). This is so presumably because filling progresses in an instant to the equilibrium state (in practice, the gravity of the resin is also added) between the surface tension of the resin, the capillary force determined by the contact angle on the template 3 and the pattern size, and the pressure of the confined air (ideally, He alone). Assuming that the pattern is a circle for the sake of convenience, a capillary pressure $\Delta P$ is represented by

$$\Delta P = 2T\cos\theta/r \qquad \qquad ...(3)$$

where T is the surface tension, $\theta$ is the contact angle, and r is the pattern radius.
A time zone b is a time zone in which the above-mentioned gas dissolves in the resin. A time zone c is a time zone in which alignment measurement in S5 can be performed. A time d is a time (first time) at which the filling is complete in the recesses forming the device pattern of the template 3. The time d is predetermined by experiments or the like by taking account of, for example, the disappearance of micro bubbles of the gas from the resin. As described previously, an alignment mark is difficult to detect if the space between the template 3 and shot is filled in the alignment mark region (second region) or the most of the recess of the alignment mark is filled with the resin. Alignment detection requires light having different phase differences. If the most of the recess is filled, there is no phase difference any longer, and this makes detection difficult. Therefore, alignment detection requires a region not filled to some extent. If the resin is filled in the alignment mark region in the same manner as when the resin is filled in the device pattern region shown in Fig. 3A, the initial stage from the start of imprint is the only time during which alignment is possible while the resin is filled. That is, if the resin is filled in the alignment region in the same manner as in the device pattern region, alignment measurement can be performed in only a partial time zone during the filling of the resin. A method of holding the contrast of an alignment mark by attaching a metal film to the mark even when a resin exists in an alignment mark region has been proposed. However, this method is difficult to carry out because it has the problems such as the durability of the metal film, the template manufacturing cost, and metal contamination.

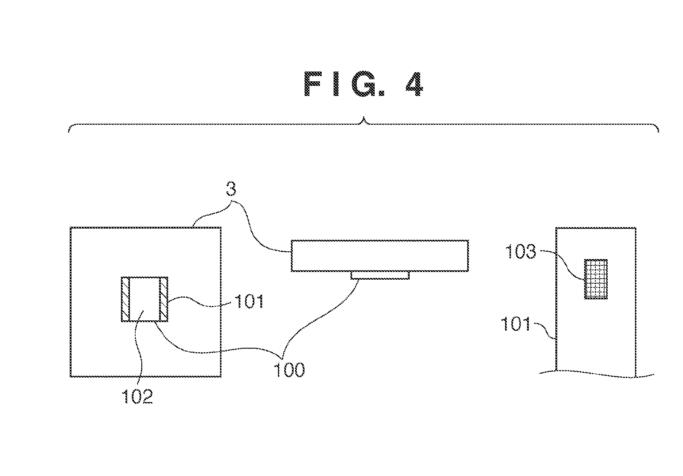

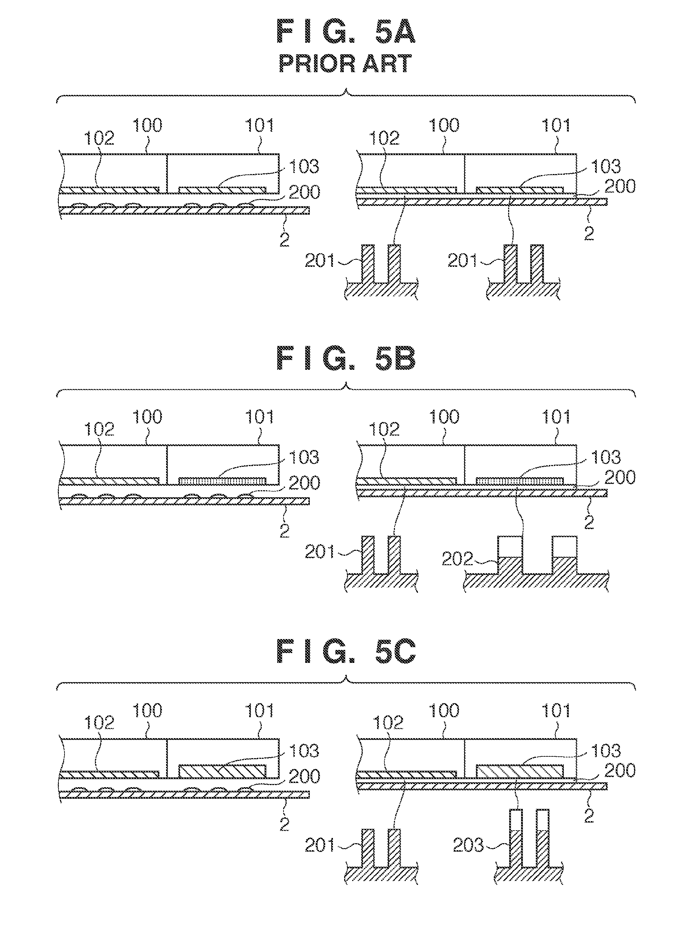

Fig. 3B is a conceptual view showing the filling of the resin according to the first embodiment. In the first embodiment as shown in Fig. 3B, the time zone a is extended and the filling ratio at the leading edge of the time zone b is decreased when compared to those shown in Fig. 3A. As a consequence, the time zone c in which alignment measurement is possible can be extended to exceed to the filling end time d. Details will be described below. Fig. 4 shows a view in which the template 3 is viewed from the pattern surface, a side view of the template 3, and an enlarged view of the alignment mark region. The template 3 has a projection called a mesa 100 which projects by about 15 to 30 $\mu$m from the base, and a pattern to be imprinted is formed on the surface of the mesa 100. The mesa 100 normally includes a region 102 having a device pattern, and scribe regions 101. In the first embodiment, the scribe regions 101 include a region having an alignment mark 103. Fig. 3A is a conceptual view showing filling in the device pattern region 102. In the device pattern region 102, the pattern width (pattern size) is very small, that is, the half pitch is a few ten nm, so the capillary pressure is high and the filling rate of the resin is high. A time at which a sufficient time has elapsed until micro bubbles or the like become $0.1/cm^2$ or less after the resin is filled is adopted as the filling end time. Conventionally, the alignment mark 103 is segmented to a small size equal to that of the device pattern, thereby increasing the capillary pressure, shortening the filling time of the whole shot, and increasing the throughput. Fig. 5A shows this method. In the device pattern region 102 and segmented alignment mark 103, a resin 200 is completely filled at almost the same filling rate as indicated by enlarged recesses 201.

By contrast, Fig. 5B shows the way the pattern surface is formed such that the minimum width of a pattern recess 202 of the alignment mark 103 is larger than the maximum width of a plurality of recesses 201 of the device pattern 102. As shown in Fig. 5B, the filling of the resin is not complete in the recess 202 of the alignment mark 103 having a large pattern size, even when the resin is completely filled in the recess 201 of the device pattern 102. The pattern size of the alignment mark 103 is appropriately larger, by about an order of magnitude or more, than that of the device pattern 102, although this also depends on the filling time.

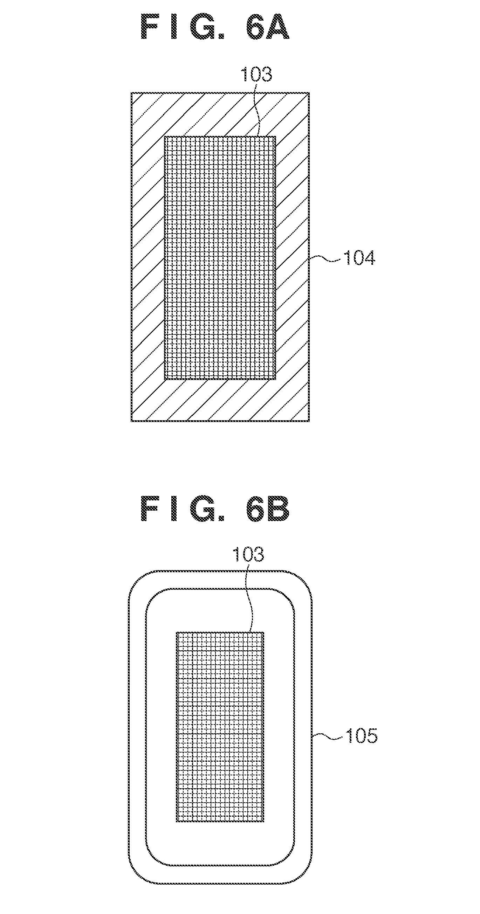

Furthermore, Fig. 5C shows the way the pattern surface is formed such that the minimum depth of a pattern recess 203 of the alignment mark 103 is larger than the maximum depth of the plurality of recesses 201 of the device pattern 102. The filling time in the alignment mark region can be prolonged by forming the alignment mark 103 having the recess 203 deeper than the recess 201 of the device pattern 102 as shown in Fig. 5C. The depth of the recess 203 depends on the alignment measurement wavelength and other optical conditions such as the refractive index. However, it is found by simulation that the depth of the recess 203 is advantageously as large as about the half wavelength from the viewpoint of the detection light amount. Moreover, as shown in Fig. 6A, a third pattern (dummy pattern) 104 which has a small size and hence makes the filling of the resin easier than in the alignment mark 103 may be formed to surround the alignment mark 103. The dummy pattern 104 like this decreases the filling rate of the resin in the alignment mark 103 because the resin to be supplied to the alignment mark 103 flows more easily to the dummy pattern 104 in the periphery. Consequently, the time zone a is prolonged, the resin filling rate at the leading edge of the time zone b is decreased, and the time zone c in which alignment measurement is possible is extended. In addition, as shown in Fig. 6B, a region (third region) having a wide trench 105 surrounding the alignment mark 103 may be formed. When using the alignment mark shown in Fig. 6B, the controller C controls the dispenser 7 to dispense the resin on the device pattern region of the wafer 2. When the template 3 is pressed against the resin dispensed on the device pattern region of the wafer 2, the resin on the outside of the trench 105 enters the alignment mark region of the wafer 2 over the trench 105. This movement of the resin makes it possible to prolong the time zone a in which the resin spreads to the alignment mark region, thereby extending the time zone c during which alignment measurement is possible. In the series of methods described above, the location and amount of a dispensed droplet are also important factors. The template for filling the resin in the alignment mark region in the imprint step as shown in Fig. 3B has been described above. In these cases, the time (second time) at which the recesses 201 in the alignment mark region (second region) are filled with the resin is later than the time (first time) at which the recesses 201 in the device pattern region (first region) are filled with the resin. Therefore, the scope 5 can reliably detect the alignment mark 103 by detecting it between the first time at which the recesses 201 of the device pattern are filled with the resin and the second time at which the recesses 201 of the alignment mark are filled with the resin.

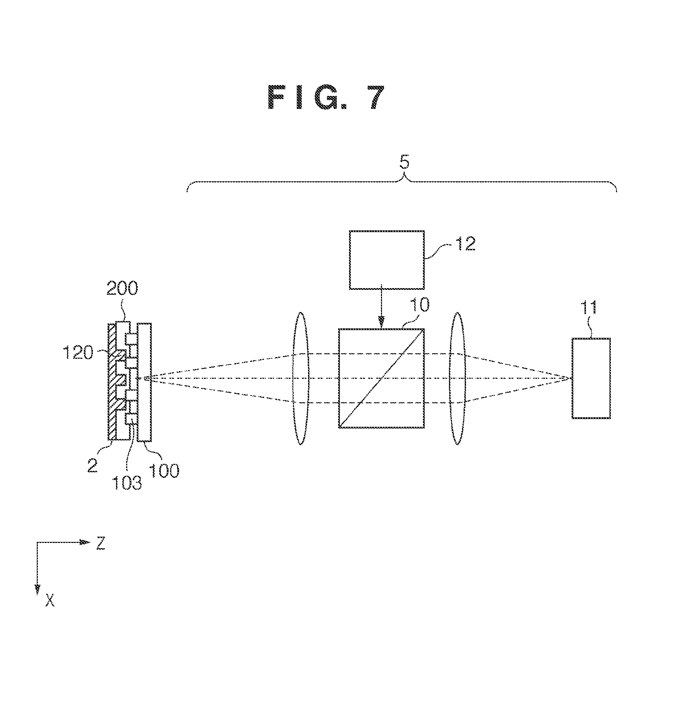

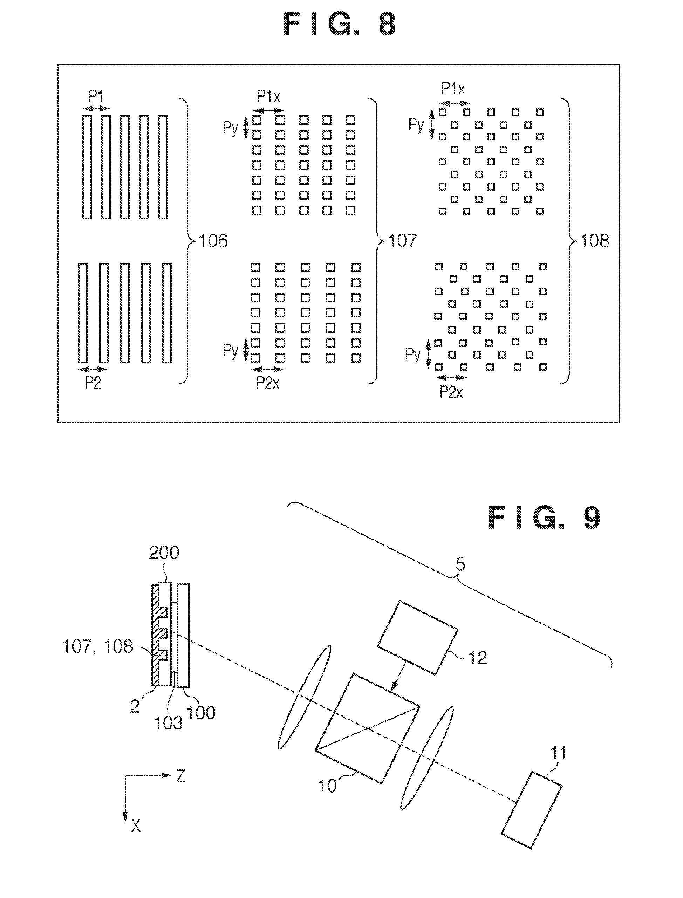

The scope 5 for detecting the alignment mark 103 formed on the template 3 will be explained below with reference to Fig. 7. An alignment mark (wafer mark) 120 on the wafer 2 and the alignment mark (template mark) 103 on the template 3 are close to each other with the resin 200 being sandwiched between them. Measurement light emitted from a light source 12 of the scope 5 and coaxially synthesized by a synthetic prism 10 irradiates the wafer mark 120. The wafer mark 120 and template mark 103 form lattice marks having different pitches so as to generate moire signals by the relative positions of these marks. A mark 106 shows in Fig. 8 is used as the pattern shape. The mark 106 has two different pitches P1 and P2, and the wafer mark 120 is formed by locating a similar mark 106 such that diffracted light propagates in the X direction. However, the corresponding mark pitches on the template side and wafer side are made different from each other. The wafer mark 120 facing the template mark 103 having the pitch P1 must have the pitch P2. The two moire signals generated by these two sets of marks pass through an imaging optical system of the scope 5, and form images on an image sensing device 11. As the synthetic prism 10, it is possible to use a half mirror, or a polarizing beam splitter by using polarized light as the measurement light. The relative position of the template 3 can be obtained as explained previously from the two moire signals generated by the positional relationship between the template mark 103 and wafer mark 120. Misalignment correction driving can always be performed during alignment by feeding back the correction amount to the apparatus. It is also possible to measure the deformation of the template 3 by installing a plurality of scopes 5 in the imprint apparatus, and arranging a plurality of template marks 103 corresponding to the observation positions of the scopes 5. As the correction driving, a correction unit 21 for correcting the driving of the wafer stage 1 and the deformation of the template 3 performs closed correction. For example, the correction unit 21 corrects the deformation of the template 3 by changing the pressure to be applied to the template 3.

If a predetermined time has elapsed and the filling end time d has come in S6, the process advances to S7, and the imprint apparatus immediately cures the resin by irradiating ultraviolet (UV) light from an illumination system 6. In this resin curing step using the UV light, the above-mentioned correction driving is stopped. The illumination system 6 is an illumination unit for irradiating an uncured resin with light that cures the uncured resin. When the UV irradiation is complete, the template 3 is released from the resin having the transferred pattern in a release step of S8, and the process advances to an imprint process for the next shot in S9. After that, the series of steps described above are repeated for all shots.

[Second Embodiment]

In the second embodiment, a scope 5 for use in the step (S5) of measuring an alignment mark 103 differs from that of the first embodiment. Fig. 9 is an enlarged view of the scope 5 of the second embodiment, which measures the alignment mark 103 by oblique illumination. One merit of the oblique illumination scope 5 is to avoid the interference with an illumination system 6. Marks 107 and 108 forming a wafer mark 120 on a wafer 2 and the template mark 103 are close to each other with a resin 200 being sandwiched between them. Light emitted from a light source 12 and coaxially synthesized by a synthetic prism 10 illuminates the marks 107 and 108. The marks 107 and 108 and the template mark 103 form lattice marks having different pitches so as to generate moire signals by the relative positions of these marks. In this arrangement, light diffracted by the marks 107 and 108 by oblique illumination must return to the optical axis of the scope 5. As shown in Fig. 8, therefore, a pitch Py of the marks 107 and 108 is adjusted so that the diffracted light propagating in the Y direction returns to the optical axis of the scope 5. The pitch Py must be fed back to design because the pitch Py depends on the wavelength of the measurement light used in the scope 5. Like the mark 106 described previously, the marks 107 and 108 include two kinds of marks having different pitches P1x and P2x. Also, the relationship between pitches P1 and P2 of the mark 106 as a template mark is designed to be the inversion of the relationship between the pitches P1x and P2x of the marks 107 and 108, as in the first embodiment. The difference between the marks 107 and 108 is whether the 0th-order diffracted light mixes in the moire signals, and the 0th-order light can be canceled by using a staggered pattern like the mark 108. When the 0th-order light is canceled, the moire signals have only one frequency obtained by two light beams. This simplifies signal processing and increases the accuracy. The two moire signals thus generated form images on an image sensing device 11 through an imaging optical system of the scope 5. The arrangement except for the scope 5 to be used is the same as that of the first embodiment, so a repetitive explanation will be omitted.

[Third Embodiment]

In the first and second embodiments, the displacement or deformation of the template 3 is measured from the displacement between the wafer mark 120 and template mark 103, and the measured displacement or deformation is corrected. However, the first and second embodiments have the problems that, for example, the wafer mark 120 is always necessary in addition to the stage reference mark 8, and the process flexibility of moire alignment is lower than that of off-axis alignment. To solve these problems, there is a method of measuring the displacement of the template mark 103 by referring to a reference mark formed in the scope 5, instead of the wafer mark 120.

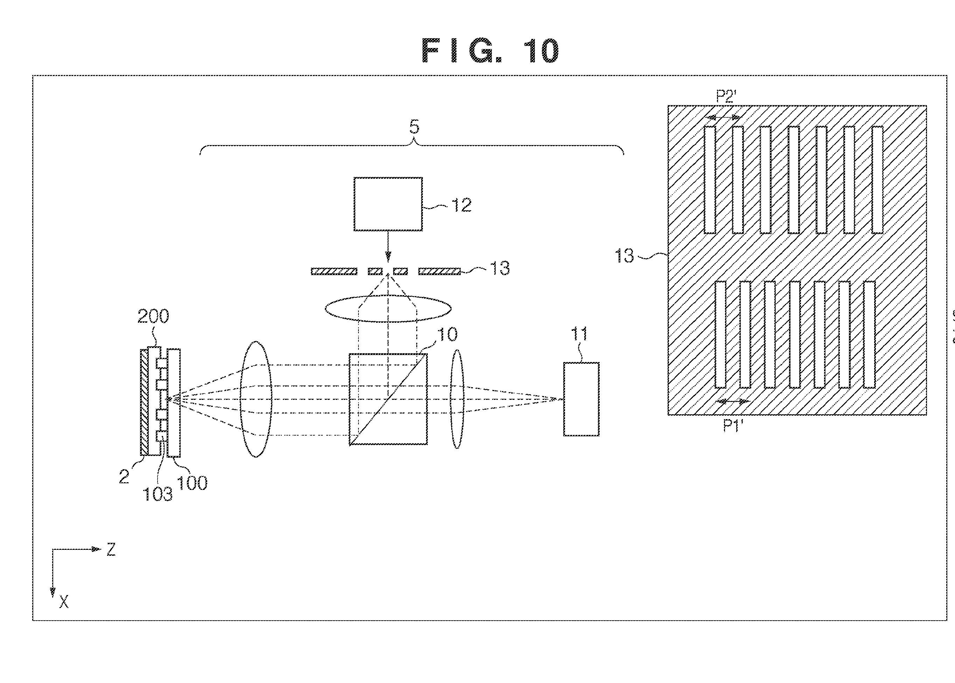

As shown in Fig. 10, in a position optically conjugate with a template mark 103, a slit 13 as a reference mark is inserted between a light source 12 and template 3. The slit 13 is a diffractive slit having two different pitches P1' and P2'. Measurement light emitted from the light source 12 and passed through the slit 13 is guided to an imaging optical system by a synthetic prism 10, and projected onto the template mark 103 (a mark similarly having two different pitches). The template mark 103 and the two sets of images of the slit 13 facing each other are designed to have inverted relationships between the pitches. The template mark 103 is close to a wafer 2 with a resin 200 being sandwiched between them. No mark exists on the substrate of the wafer 2. As in the first embodiment, when measuring the template mark 103, the resin 200 is not filled in the recesses of the template mark 103, so the above-mentioned slit image is reflected by only the recesses of the template mark 103 not in contact with the resin 200. Then, moire diffracted light of the slit image and template mark 103 is guided to the imaging optical system in the scope 5. The moire diffracted light passes through the imaging optical system in the scope 5, and forms a moire image on an image sensing device 11. The two sets of moire signals formed are simultaneously observed. The relative positional relationship of the template 3 can be calculated based on the relative positional relationship between the image of the slit 13 and the template mark 103. More specifically, the displacement and deformation of the template 3 based on the slit 13 can always be measured, that is, even when no resin is dispensed. In the third embodiment, correction driving of the template 3 can be performed even when no resin is dispensed, because the template 3 can always be measured.

[Fourth Embodiment]

In the fourth embodiment, a scope 5 identical to that of the third embodiment is installed to perform oblique illumination with respect to a template 3. The rest of the arrangement is the same as that of the third embodiment, so a repetitive explanation will be omitted. As in the third embodiment, the displacement and deformation of the template 3 based on a slit 13 can always be measured, that is, can be measured even when no resin is dispensed, in this embodiment as well. Also, correction driving of the template 3 can be performed even when no resin is dispensed, because the template 3 can always be measured.

[Fifth Embodiment]

Fig. 3C is a conceptual view showing the filling of a resin in the fifth embodiment. The feature of this embodiment is to suppress or stop the filling of a resin by, for example, preventing the dissolution of He or weakening the capillary force while He dissolves in the resin in a time zone b. Although Fig. 3C shows that the filling stops from a certain time, Fig. 3C is merely a conceptual view, and the purpose of this embodiment is to largely extend an alignment measurement enable time c with respect to a predetermined filling end time d by decreasing the filling rate.

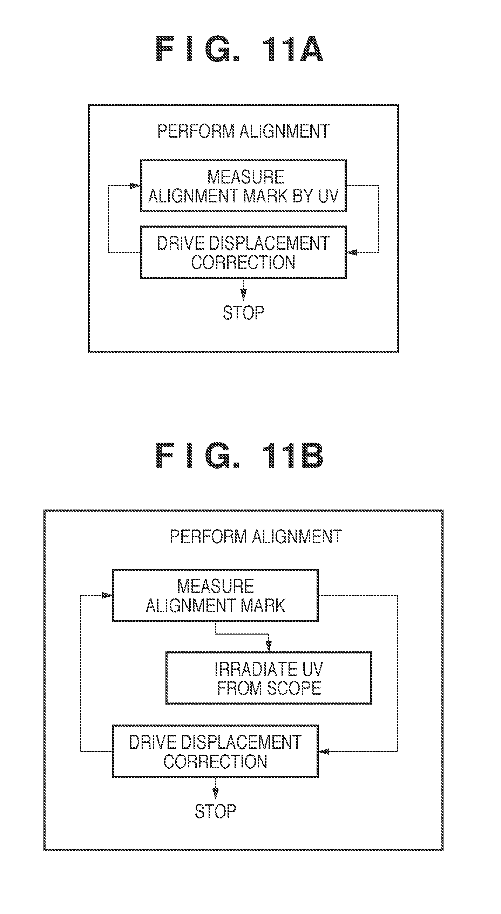

Steps from S1 to S4 are the same as those of the first embodiment. In S5, the process advances to an alignment step. In the alignment step, a scope 5 emits UV light as alignment mark measurement light, as shown in Fig. 11A. As shown in Fig. 7, the displacement and deformation of a template 3 are measured by moire diffracted light generated by a wafer mark 120 and template 103, and the measured displacement and deformation of the template 3 are corrected by a closed loop. The wavelength of UV light emitted from a light source 12 of the scope 5 can be any wavelength as long as the wavelength is the same as that of light irradiated by an illumination system 6, or exists in a wavelength band in which a resin 200 causes a crosslinking reaction. Accordingly, the scope 5 is designed to have the wavelength of the above-mentioned UV light.

The irradiation region of the UV light irradiated from the scope 5 is limited to the region of the template mark 103, so the curing of the resin 200 progresses in the region sandwiched between the wafer mark 120 and template mark 103. Consequently, the filling of the resin advances in regions except for the region of the template mark 103, but slows down or stops in the region of the template mark 103. The timing of UV irradiation by the scope 5 depends on the relationship between the UV curing rate, diffusion rate, and filling rate of the resin. However, if UV irradiation is performed before the resin 200 spreads over the entire region of the template mark 103, the resin nonuniformly cures, and this sometimes causes an alignment measurement error or prevents smooth mold release. Therefore, a time zone from the time at which the resin 200 has sufficiently spread over the entire region of the template mark 103 to the middle of the period during which the resin is filled in the recesses of the template mark 103, that is, the time zone b is desirable. After that, a predetermined filling time is over (S6), and alignment measurement and template displacement correction and deformation correction are performed by a closed loop until the illumination system 6 starts a UV curing step (S7). Then, the process advances to steps from mold release similar to those of the first embodiment. In the fifth embodiment, alignment measurement and correction can be performed in the same manner as in the second embodiment even when the scope 5 is an oblique illumination scope. It is also possible to use a scope 5 that performs the alignment measurement of a template mark and reference slit, as in the third and fourth embodiments.

[Sixth Embodiment]

In the fifth embodiment, the same UV light is used as the light for decreasing the filling rate of the resin, and as the alignment mark measurement light. In the sixth embodiment, light having a wavelength different from that of UV light for decreasing the filling rate of the resin is used as the alignment mark measurement light. Since the UV curing of the resin does not occur at the wavelength of the alignment mark measurement light, resin curing in the alignment mark region and alignment measurement are independently performed in parallel. This makes it possible to more accurately control the filling rate of the resin without decreasing the throughput.

Steps from S1 to S4 are the same as those of the first embodiment. In S5, the process advances to an alignment step. In the alignment step, as indicated by a flowchart shown in Fig. 11B, a light source 12 of a scope 5 emits measurement light, and alignment measurement and template displacement correction and deformation correction are performed by a closed loop as in the fifth embodiment. However, the scope 5 of the sixth embodiment is designed by the wavelength of the alignment mark measurement light. In addition, as will be described later, moire diffracted light of the UV light also mixes in an image sensing device 11 at the same time. From the viewpoint of the measurement accuracy, therefore, it is desirable to pass only the measurement light by, for example, inserting a bandpass filter immediately before the image sensing device 11. The wavelength of the measurement light emitted from the light source 12 of the scope 5 is set in a wavelength band in which a resin 200 causes no crosslinking reaction. Almost simultaneously, another light source irradiates UV light. Since UV irradiation is limited to the region of a template mark 103, the curing of the resin 200 advances in the region of the template mark 103. It is also possible to optimally control the resin curing rate by independently controlling UV irradiation.

As in the fifth embodiment, the timing of UV irradiation from the scope 5 is desirably a time zone from the time at which the resin 200 has sufficiently spread over the entire region of the template mark 103 to the middle of the period during which the resin is filled to the depth of each recess of the template mark 103. The timing of alignment measurement is not particularly limited. In addition, the UV irradiation timing can be fed back to the apparatus in real time by monitoring the diffusion state of the resin 200 by using this alignment measurement image.

In the sixth embodiment, alignment measurement and correction can be performed in the same manner as in the second embodiment even when the scope 5 is an oblique illumination scope. It is also possible to use a scope 5 that performs the alignment measurement of a template mark and reference slit, as in the third and fourth embodiments.

[Article Manufacturing Method]

A method of manufacturing a device (for example, a semiconductor integrated circuit device or liquid crystal display device) as an article includes a step of transferring (forming) patterns onto a substrate (wafer, glass plate, or film-like substrate) by using the above-described imprint apparatus. This manufacturing method can further include a step of etching the substrate having the transferred patterns. Note that when manufacturing another article such as a patterned medium (recording medium) or optical device, the manufacturing method can include another step of processing the substrate having the transferred patterns, instead of the etching step. Although the embodiments of the present invention have been explained above, the present invention is not limited to these embodiments, and various modifications and changes can be made within the spirit and scope of the invention.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. An imprint apparatus includes a dispenser (7), a detector (5) configured to detect an alignment mark (103) located on a pattern surface of a template, and a controller (C). The pattern surface includes a first region (102) including a pattern corresponding to the resin pattern, and a second region (101) including the alignment mark, and is formed such that a second time when a recess in the second region is filled with the uncured resin is later than a first time when a recess in the first region is filled with the uncured resin. The controller causes the dispenser to dispense, on the substrate, the uncured resin that has an amount such that the recesses in the first and second regions are filled with the uncured resin and causes the detector to detect the alignment mark between the first time and the second time.

**Claims**

1.   An imprint apparatus configured to perform an imprint process that forms, on a substrate (2), a resin pattern for manufacturing an article, using an uncured resin and a template, the apparatus **characterized by** comprising:

a dispenser (7) configured to dispense the uncured resin on the substrate;
a detector (5) configured to detect an alignment mark (103) located on a pattern surface of the template using light; and
a controller (C),
wherein the pattern surface includes a first region (102) including a pattern corresponding to the resin pattern, and a second region (101) including the alignment mark, and is formed such that a second time at which a recess in the second region is filled with the uncured resin is later than a first time at which a recess in the first region is filled with the uncured resin, and
the controller is configured to cause the dispenser to dispense, on the substrate, the uncured resin that has an amount such that the recess in the first region and the recess in the second region are filled with the uncured resin, and to cause the detector to detect the alignment mark between the first time and the second time.

2.   The apparatus according to claim 1, **characterized in that** the pattern surface is formed such that a minimum width of the recess in the second region is larger than a maximum width of the recess in the first region.

3.   The apparatus according to claim 1, **characterized in that** the pattern surface is formed such that a minimum depth of the recess in the second region is larger than a maximum depth of the recess in the first region.

4.  The apparatus according to claim 1, **characterized in that**
the pattern surface further includes a third region including a third pattern surrounding the alignment mark, and
the pattern surface is formed such that a maximum width of a recess in the third region is smaller than a minimum
width of the recess in the second region.

5.  An imprint apparatus configured to perform an imprint process that forms, on a substrate (2), a resin pattern for
manufacturing an article, using an uncured resin and a template, the apparatus **characterized by** comprising:

> a dispenser (7) configured to dispense the uncured resin on the substrate;
> a detector (5) configured to detect an alignment mark (103) located on a pattern surface of the template using
> light; and
> a controller (C),
> wherein the pattern surface includes a first region (102) including a pattern corresponding to the resin pattern,
> a second region (101) including the alignment mark, and a third region (105) including a moat surrounding the
> alignment mark, and
> the controller is configured to cause the dispenser to dispense, on the first region, the uncured resin that has
> an amount such that a recess in the first region, a recess in the second region, and a recess in the third region
> are filled with the uncured resin, and to cause the detector to detect the alignment mark between a first time at
> which the recess in the first region is filled with the uncured resin, and a second time at which the recess in the
> third region is filled with the uncured resin having moved over the second region from the first region.

6.  An imprint apparatus configured to perform an imprint process that forms, on a substrate (2), a resin pattern for
manufacturing an article, using an uncured resin and a template, the apparatus **characterized by** comprising:

> a dispenser (7) configured to dispense the uncured resin on the substrate;
> a detector (5) configured to detect an alignment mark (103) located on a pattern surface of the template using light;
> an irradiation unit configured to irradiate the uncured resin with a light which cures the uncured resin; and
> a controller (C),
> wherein the pattern surface includes a first region (102) including a pattern corresponding to the resin pattern,
> and a second region (101) including the alignment mark, and
> the controller is configured to cause the dispenser to dispense, on the substrate, the uncured resin that has an
> amount such that a recess in the first region and a recess in the second region are filled with the uncured resin,
> cause the irradiation unit to irradiate and cure the uncured resin in the recess in the second region after the
> uncured resin has entered the recess in the second region and before the recess in the second region is filled
> with the uncured resin, and to cause the detector to detect the alignment mark in a state in which the uncured
> resin in the recess in the second region is cured.

7.  The apparatus according to claim 6, **characterized by** further comprising an irradiation unit configured to irradiate
the uncured resin in the recess in the first region with a light which cures the uncured resin, after the recess in the
first region is filled with the uncured resin.

8.  A method of manufacturing an article, the method **characterized by** comprising:

> forming a resin pattern on a substrate using an imprint apparatus according to any one of claims 1 to 7; and
> processing the substrate on which the resin pattern has been formed, to manufacture the article.

9.  A template (3) for use in an imprint apparatus configured to perform an imprint process that forms, on a substrate
(2), a resin pattern for manufacturing an article, using an uncured resin and the template,
the template **characterized by** comprising a pattern surface including a first region (102) including a pattern corresponding to the resin pattern, and a second region (101) including an alignment mark (103),
the pattern surface being formed such that a second time at which a recess in the second region is filled with the
uncured resin is later than a first time at which a recess in the first region is filled with the uncured resin.

# F I G. 1

FIG. 2

PERFORM
GLOBAL ALIGNMENT — S1

↓

MOVE FIRST SHOT — S2

↓

DISPENSE RESIN — S3

↓

IMPRINT — S4

PERFORM ALIGNMENT — S5

MEASURE
ALIGNMENT MARK

↓

DRIVE DISPLACEMENT
CORRECTION

↓

STOP

TERMINATE
FILLING — S6

↓

CURE BY UV — S7

↓

RELEASE — S8

↓

TO NEXT SHOT — S9

FILLING
RATIO
100%

d

F I G. 3A

a    b                    TIME

FILLING
RATIO

c              d

100%

F I G. 3B

a              b          TIME

FILLING
RATIO

c              d

100%

F I G. 3C

a              b          TIME

# F I G. 4

# F I G. 5A
## PRIOR ART

# F I G. 5B

# F I G. 5C

# F I G. 6A

103

104

# F I G. 6B

103

105

# F I G. 7

# FIG. 8

# FIG. 9

# FIG. 10

EP 2 360 524 A2

# F I G. 11A

PERFORM ALIGNMENT

MEASURE
ALIGNMENT MARK BY UV

DRIVE DISPLACEMENT
CORRECTION

STOP

# F I G. 11B

PERFORM ALIGNMENT

MEASURE
ALIGNMENT MARK

IRRADIATE UV
FROM SCOPE

DRIVE DISPLACEMENT
CORRECTION

STOP

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4185941 B